Europäisches Patentamt

European Patent Office

Office européen des brevets

(11) Publication number: 0 514 614 A1

# EUROPEAN PATENT APPLICATION

(21) Application number: 91710019.0

(22) Date of filing: 24.05.91

(51) Int. Cl.5: C04B 35/49, C01G 25/00, H01L 41/18, H01B 3/12

(43) Date of publication of application:
25.11.92 Bulletin 92/48

(84) Designated Contracting States:
DE FR GB

(71) Applicant: FUJI DENKI KAGAKU KABUSHIKI KAISHA
36-11, Shinbashi 5-Chome, Minato-Ku
Tokio-To(JP)

(72) Inventor: Kihara, Utsuo
2477-34, Washizu
Kosai-Shi, Shizuoka-Ken(JP)
Inventor: Endo, Kazuaki
1534, Kibi
Kosai-Shi, Shizuoka-Ken(JP)
Inventor: Fukuoka, Shuichi
4306-8, Shimomachi, Buiwara
Yatsushiro-Shi, Kumamoto-Ken(JP)
Inventor: Akagishi, Masahiko
2-3-10, Sakae-Cho
Atsugi-Shi, Kanagawa-Ken(JP)

(74) Representative: Hassler, Werner, Dr.
Postfach 17 04 Asenberg 62
W-5880 Lüdenscheid(DE)

(54) Complex perovskite compounds and a process for producing the same.

(57) The present invention relates to a complex perovskite compound useful as a finely divided low hysteresis and piezoelectric actuator material, and a process for producing the same. That is, a complex perovskite compound represented by the general formula:

$Pb_{1-x}Sr_x(Zr_{1-y}Ti_y)O_3$
$+ Sb_2O_3$ ($\alpha$ weight percent)
$+ MnO_2$ ($\beta$ weight percent)
$+ PbO$ ($\gamma$ weight percent)

wherein x, y, $\alpha$, $\beta$ and $\gamma$ are numbers in the range represented by $0.4 \leq x \leq 0.6$, $0.4 \leq y \leq 0.55$, $1.5 \leq \alpha \leq 1.7$, $0.45 \leq \beta \leq 0.5$ and $0 \leq \gamma \leq 3.8$ in which the mean particle size of a powder is no more than 0.09 micrometers; and a process for producing a complex perovskite compound comprising blending alkoxide compounds of Pb, Sr, Zr, Ti, Mn and Sb metals in their stoichiometric proportions, mixing said metal alkoxide compounds in an organic solvent having a boiling point of at least 100°C to obtain a mixture, adding water to the mixture at a rate of no more than 5 milliliters per minute based on the organic solvent having dissolved said metal alkoxide compounds to deposit a hydrolyzate, and firing said hydrolyzate.

## BACKGROUND OF THE INVENTION

This invention relates to a complex perovskite compound useful as a finely divided low hysteresis and piezoelectric actuator material, and a process for producing the same.

Heretofore, complex perovskite structure compounds containing Pb, Sr, Zr, Ti, Mn and Sb metals have been produced by mixing oxides of respective metals, calcining the mixture, and grinding and firing it.

The production of a complex perovskite compound comprising dissolving alkoxide compounds of Pb, Sr, Zr, Ti, Mn and Sb metals in an organic solvent and thereafter adding water to the resulting solution to hydrolyze the alkoxide compounds has also been known from Nippon Ceramic Association Paper 96 [2] 140-45, 1988 and the like.

However, the complex perovskite structure compounds produced via the grinding step using such metal oxides have the following drawbacks. It is difficult to obtain a uniform solid solution state. Further, the compounds are produced by mechanical grinding means and therefore their particle size distribution is wide and the particle shape is heterogeneous. Thus, ultrafine particles having a particle size of no more than 0.5 micrometers cannot be obtained.

In the process described in the Nippon Ceramic Association Paper 96 [2] 140-45, 1988 wherein the metal alkoxide compounds are dissolved in an organic solvent and water is then added to carry out hydrolysis, n-propanol is actually used as the organic solvent and therefore the resulting complex perovskite compound is fine particles having a considerably fine particle size. However, these fine particles coalesce into secondary particles having a size of from about 0.1 to about 0.5 micrometers.

Accordingly, the particle size of a sintered body of the complex perovskite compounds obtained by such a grinding method and such a hydrolysis method via dissolution in n-propanol is generally several micrometers and the resulting complex perovskite compounds have a domain structure. Therefore, when they are used as an actuator, the state of the domain can vary by the change in electric field and hysteresis occurs with respect to voltage-displacement characteristics.

Further, the sintered body exhibits a heterogeneous solid solution state and therefore a difference in distribution of piezoelectric activity occurs in an element. In such a case, it is difficult to carry out precise positioning in a nanometer order and no reproducibility is obtained.

## SUMMARY OF THE INVENTION

We have now found that a product obtained by mixing specific alkoxide compounds of metals with a specific organic solvent and then slowly adding water to carry out hydrolysis to deposit, is a uniform and extremely fine particle of a compound having a high purity and a complex perovskite structure and that such a particle is useful as a low hysteresis and piezoelectric actuator material.

That is, the present invention relates to a complex perovskite compound represented by the general formula:

$Pb_{1-x}Sr_x(Zr_{1-y}Ti_y)O_3$
+ $Sb_2O_3$ ($\alpha$ weight percent)
+ $MnO_2$ ($\beta$ weight percent)
+ $PbO$ ($\gamma$ weight percent)

wherein x, y, $\alpha$, $\beta$ and $\gamma$ are numbers in the range represented by $0.4 \leq x \leq 0.6$, $0.4 \leq y \leq 0.55$, $1.5 \leq \alpha \leq 1.7$, $0.45 \leq \beta \leq 0.5$ and $0 \leq \gamma \leq 3.8$ in which the mean particle size of a powder is no more than 0.09 micrometers.

The present invention also relates to a process for producing a complex perovskite compound which comprises the steps of blending alkoxide compounds of Pb, Sr, Zr, Ti, Mn and Sb metals in their stoichiometric proportions, mixing said metal alkoxide compounds in an organic solvent having a boiling point of at least 100°C to obtain a mixture, adding water to the mixture at a rate of no more than 5 milliliters per minute based on the organic solvent having dissolved said metal alkoxide compounds to deposit a hydrolyzate and firing said hydrolyzate.

The complex perovskite compound of the present invention is a mixture of a perovskite compound and other metal oxides wherein the mean particle size of a powder is no more than 0.09 micrometers.

A sintered body having a complex perovskite structure and having a uniform and fine particle size is obtained by blending metal alkoxide compounds in their stoichiometric proportions, mixing metal alkoxide compounds in an organic solvent having a boiling point of at least 100°C to obtain a mixture, slowly adding water such as distilled water or steam to the mixture in small portions at a rate of no more than 5 milliliters per minute based on the organic solvent having dissolved the metal alkoxide compounds by stirring in order to minimize the influence due to differences in the rate of hydrolysis reaction of each metal alkoxide compound, thereby gradually hydrolyzing the metal alkoxide compounds dissolved in a solvent such as xylene, having a boiling point of at least 100°C, to deposit each metal alkoxide compound as a metal oxide insoluble in the solvent such as xylene to form a precipitate, and firing the precipitate.

The sintered body thus obtained exhibits the same characteristics under any conditions when there is measured its behavior associated with the temperature-inducing change of a permittivity obtained by attaching electrodes and varying an alternating current voltage. Further, the foregoing and the result of observation by means of a polarization microscope indicate that the sintered body exhibits a substantially single domain structure. Fine particles having such a structure exhibit a property excellent in the voltage-displacement characteristics of piezoelectric ceramics and are extremely useful as a low hysteresis and piezoelectric actuator material.

## DETAILED DESCRIPTION OF THE PREFERRED EMBODIMENTS

[I] Complex Perovskite Compound

(1) Structure

A complex perovskite compound of the present invention has a structure represented by the general formula:

$Pb_{1-x}Sr_x(Zr_{1-y}Ti_y)O_3$
+ $Sb_2O_3$ ($\alpha$ weight percent)
+ $MnO_2$ ($\beta$ weight percent)
+ $PbO$ ($\gamma$ weight percent)

wherein x, y, $\alpha$, $\beta$ and $\gamma$ are numbers in the range represented by $0.4 \leq x \leq 0.6$, $0.4 \leq y \leq 0.55$, $1.5 \leq \alpha \leq 1.7$, $0.45 \leq \beta \leq 0.5$ and $0 \leq \gamma \leq 3.8$; preferably a structure represented by the general formula:

$Pb_{1-x}Sr_x(Zr_{1-y}Ti_y)O_3$
+ $Sb_2O_3$ (1.68 weight percent)
+ $MnO_2$ (0.50 weight percent)
+ $PbO$ (3.85 weight percent)

wherein x is a number in the range represented by $0.4 \leq x \leq 0.6$ and y is a number in the range represented by $0.49 \leq y \leq 0.52$.

The compounds represented by such general formulae have been found to be complex perovskite compounds from the following facts. When a (1 0 1) face of a diffraction pattern is examined by a X-ray analysis and an analytical electron microscopy, peak bifurcation does not occur and therefore a solid solution is obtained. Further, an analytical electron microscope confirms that the distribution of elements is uniform and that its composition is retained.

(2) Nature

The complex perovskite compound having the structure described above has a mean particle size of no more than 0.09 micrometers, preferably from 0.04 to 0.07 micrometers. The complex perovskite compound exhibits such a particle size distribution that particles having a mean particle size of from 0.068 to 0.072 micrometers comprise from 90 to 95% by weight. From the foregoing, the complex perovskite compound is understood to be composed of ultrafine particles having a uniform particle size.

When an ultrafine particle powder composed of such complex perovskite compounds is subjected to sintering or hot press at a relatively low temperature, they can be converted into an aggregate of particles which has a single domain structure.

When ceramics composed of such an aggregate are used as an element for a piezoelectric actuator, they exhibit a property excellent in voltage-displacement characteristics of piezoelectric ceramics and are extremely useful as a low hysteresis and piezoelectric actuator material.

[II] Process For Producing Complex Perovskite Compounds

(1) Raw Material

(a) Alkoxide Compounds of Metals

Raw materials used for producing the complex perovskite compounds described above include alkoxide compounds of Pb, Sr, Zr, Ti, Mn and Sb metals.

Examples of such metal alkoxide compounds include the following compounds:

$Pb(O\text{-}i\text{-}C_3H_7)_2$, $Sr(O\text{-}i\text{-}C_3H_7)_2$, $Zr(O\text{-}i\text{-}C_3H_7)_4$, $Ti(O\text{-}i\text{-}C_3H_7)_4$, $Mn(O\text{-}i\text{-}C_3H_7)_2$, $Sb(O\text{-}i\text{-}C_3H_7)_3$, $Ti(O\text{-}i\text{-}C_4H_9)_4$, $Zr(O\text{-}i\text{-}C_4H_9)_4$, $Ti(OCH_3)_4$, $Zr(OCH_3)_4$, $Sr(OCH_3)_2$, $Sb(OCH_3)_3$, and the like.

Of these, preferred metal alkoxide compounds for use herein are

$Pb(O\text{-}i\text{-}C_3H_7)_2$, $Sr(O\text{-}i\text{-}C_3H_7)_2$, $Zr(O\text{-}i\text{-}C_3H_7)_4$, $Ti(O\text{-}i\text{-}C_3H_7)_4$, $Mn(O\text{-}i\text{-}C_3H_7)_2$, $Sb(O\text{-}i\text{-}C_3H_7)_3$.

The alkoxide compounds of the Pb, Sr, Zr, Ti, Mn and Sb metals described above are mixed in the same stoichiometric proportions as those of the composition of the complex perovskite compound to be obtained.

(b) Organic Solvent

In the process for producing the complex perovskite compound of the present invention, an organic solvent is used in order to dissolve the metal alkoxide compounds described above.

It is important that a solvent having a boiling point of at least 100°C be used as such an organic solvent.

Such solvents having a boiling point of at least 100°C include xylene, toluene, pentanol, isobutyl alcohol, nitrobenzene and the like. Such solvents may be used in mixture. Of these, preferred solvents are xylene, toluene, pentanol and isobutyl alcohol. A particularly preferred solvent is xylene.

(2) Dissolution

The dissolution of the metal alkoxide compounds described above can be carried out in the same manner as a usual dissolution method. For example, the metal alkoxide compounds can be dissolved by stirring them for from 5 to 10 hours, particularly under reflux of the solvent having a boiling point of at least 100°C while heating at a temperature of from 1000 to 130°C, preferably from 100° to 110°C.

The amount of the solvent having a boiling point of at least 100°C used is an amount capable of dissolving the total amount of the metal alkoxide compounds described above, generally an amount in the range of from 10 to 20 liters, preferably from 10 to 15 liters per each mole of each metal alkoxide compound.

(3) Hydrolysis

Water such as distilled water or steam, but preferably steam in an amount of from 10 to 20 times, preferably from 10 to 15 times an amount necessary for hydrolysis of the metal alkoxide compounds, is slowly added in small portions to the thus obtained mixture of the metal alkoxide compounds with the solvent having a boiling point of at least 100°C at a rate of no more than 5 milliliters per minute, preferably from 1 to 2 milliliters per minute based on the organic solvent having dissolved the metal alkoxide compounds with stirring in order to minimize the influence due to differences in the rate of hydrolysis reaction of each metal alkoxide compound, thereby gradually hydrolyzing the metal alkoxide compounds dissolved in the solvent having a boiling point of at least 100°C. The hydrolysis reaction is usually carried out by stirring for from 3 to 10 hours at a temperature of from 90° to 100°C, preferably from 95° to 100°C, preferably under reflux of the solvent having a boiling point of at least 100°C.

This hydrolysis reaction converts each metal alkoxide compound into a metal oxide insoluble in the solvent having a boiling point of at least 100°C to deposit the metal oxides, thereby forming a precipitate.

If water is rapidly fed to facilitate the hydrolysis reaction, the composition of a product will become different due to differences in the hydrolysis reaction rate of each metal alkoxide compound. Therefore, it is important to minimize such an influence in order to obtain a precipitate having a high uniformity.

Accordingly, water described above is fed at such a slow rate that differences in the hydrolysis reaction rate of each metal alkoxide compound do not occur.

Because the resulting uniformity and size of particles have particularly an influence on the performance of the desired actuator, it is important to use such conditions that minimize the non-uniformity of composition distribution due to differences in the respective reaction rates of the metal alkoxide compounds.

Usually, it is desirable to add water at a rate of from 1 to 5parts by weight per minute, preferably from 1 to 2 parts by weight per minute based on the solvent having a boiling point of at least 100°C.

(4) Firing Procedure

(a) Calcining

The thus obtained precipitate is dried. Thereafter, the dried precipitate is usually calcined at a temperature of from 580° to 650°C, preferably from 600° to 630°C to obtain a metal powder prior to the subsequent firing.

(b) Firing

A firing is carried out after calcining described above. Alternatively, the firing is carried out without calcining.

The firing is generally carried out by subjecting the precipitate to sintering or hot press for from 1 to 5 hours at a relatively low temperature of from 850° to 1,000°C, preferably from 850° to 900°C to obtain an aggregate of particles which has a single domain structure.

[III] Physical Properties

When ceramics composed of the aggregate of an ultrafine particle powder of the above composition composed of the thus obtained complex perovskite compound are used as an element for a piezoelectric actuator, they exhibit a property excellent in voltage-displacement characteristics of piezoelectric ceramics and is extremely useful as a low hysteresis and piezoelectric actuator material.

Examples 1 and 2

(1) Dissolution

A mixture of metal alkoxides having composition comprising 9.6% by mole of Pb alkoxide ($Pb(O-i-C_3H_7)_2$), 0.4% by mole of Sr alkoxide ($Sr(O-i-C_3H_7)_2$), 5.1% by mole of Zr alkoxide ($Zr(O-i-C_3H_7)_4$), 4.9% by mole of Ti alkoxide ($Ti(O-i-C_3H_7)_4$), 0.184% by mole of Mn alkoxide ($Mn(O-i-C_3H_7)_2$) and 0.369% by mole of Sb alkoxide ($Sb(O-i-C_3H_7)_3$) was added to 2 liters of xylene (metal alkoxide mixture/xylene = 0.1 moles/liter) and the solution was refluxed for 10 hours at a temperature of 130°C with stirring.

(2) Hydrolysis

Thereafter, distilled water at 95°C which had a pH of 7.8 was slowly added to this solution, in an amount of 10 times the theoretical amount at a rate of 1 milliliter per minute, and the resulting mixture was refluxed for 10 hours at a temperature of 100°C with stirring to carry out hydrolysis.

The resulting precipitate was filtered off and dried to obtain a powder.

(3) Firing

This dried powder was calcined for 2 hours at a temperature of 630°C to obtain a metallic fine powder having a mean particle size of 0.07 micrometers.

The metallic fine powder was found to be an ultrafine particle-shaped compound having a complex perovskite structure from the following facts. When a (1 0 1) face of a diffraction pattern of X-ray analysis was examined, peak bifurcation did not occur and therefore a solid solution was obtained. Further, an analytical electron microscope confirmed that the distribution of elements was uniform and that its composition was retained.

(4) Physical Properties

The thus obtained ultrafine particle-shaped compound having a complex perovskite structure was subjected to forming by means of a press machine, and the resulting form was fired for 2 hours in air at 850°C to obtain a sintered body.

It was confirmed that the mean particle size of this sintered body was no more than about 0.4 micrometers and that the sintered body had a considerably smaller particle size when compared with the mean particle size (about 7-8 micrometers) of the complex perovskite compound obtained by the prior grinding method.

The sintered body obtained herein exhibited the same characteristics under all conditions when the behavior was measured associated with the temperature-inducing change of a permittivity obtained by attaching electrodes to the sintered body and varying a direct current biasing voltage. Further, the foregoing and the result of observation by means of a polarization microscope confirmed that the sintered body exhibited a substantially single domain structure.

The voltage-displacement characteristics of piezoelectric ceramics composed of the sintered body thus obtained were examined. The results are shown in Table 1.

TABLE 1

| | $d_{31}$ ($\times 10^{-12}$) (m/v) | Density ($\times 10^3$) (kg/m$^3$) | Dielectric Constant $\epsilon_{33}t/\epsilon_0$ | Firing Temperature (°C) | Calcining Temperature (°C) | Dielectric Loss tan $\delta_E$ (%) |
|---|---|---|---|---|---|---|
| Example 1 | -80 | 7.725 | 1050 | 850 | 630 | 0.369 |
| Example 2 | -40 | 7.730 | 535 | 850 | 630 | 0.301 |

Comparative Example 1

A complex perovskite compound was produced as in Example 1 except that n-propanol was used in place of xylene as a solvent dissolving the metal alkoxides and water for carrying out hydrolysis was rapidly added at a rate of 7 milliliters per minute.

The fine powder of the resulting complex perovskite compound coalesced and the mean particle size of the coarlesced product was 0.2 micrometers. Accordingly, the particle size of the product of Comparative Example 1 is remarkably larger than that of an ultrafine powder of the complex perovskite compound of the present invention.

This fine powder was subjected to forming and fired. The voltage-displacement characteristics of piezoelectric ceramics composed of the sintered body were examined. The results are shown in Table 2.

Comparative Example 2

PbO, SrO, $ZrO_2$, $TiO_2$, $MnO_2$ and $Sb_2O_3$ metal oxides were mixed in the same molar ratio as that of Example 1 to obtain a mixture of the metal oxides. This mixture of the metal oxides was then calcined for 7 hours at a temperature of 900°C to obtain a metal oxide powder.

This was then ground under wet conditions and thereafter the ground product was kneaded using polyvinyl alcohol as a binder and the kneaded mixture was subjected to forming as in Example 1. The firing was again carried out for 3 hours at a temperature of 1,200°C to obtain a sintered body composed of metal oxides.

The particle size of a powder of this metal oxide sintered body was measured. The mean particle size was from 7 to 8 micrometers and it proved that the particle size was considerably large.

When this metal oxide sintered body was subjected to an X-ray analysis, it proved that the resulting product was a complex perovskite structure compound as in Example 1.

The voltage-displacement characteristics of piezoelectric ceramics composed of the resulting sintered body were examined. The results are shown in Table 2.

TABLE 2

| | $d_{31}$ ($\times 10^{-12}$) (m/v) | Density ($\times 10^3$) (kg/m$^3$) | Dielectric Constant $\epsilon_{33}t/\epsilon_0$ | Firing Temperature (°C) | Calcining Temperature (°C) | Dielectric Loss tan $\delta_E$ (%) |
|---|---|---|---|---|---|---|
| Comparative Example 1 | -70 | 7.695 | 650 | 850 | 630 | 1.273 |
| Comparative Example 2 | -150 | 7.700 | 1600 | 1200 | 950 | 0.579 |

**Claims**

1. A complex perovskite compound represented by the general formula:

$Pb_{1-x}Sr_x(Zr_{1-y}Ti_y)O_3$
+ $Sb_2O_3$ ($\alpha$ weight percent)
+ $MnO_2$ ($\beta$ weight percent)
+ $PbO$ ($\gamma$ weight percent)

wherein x, y, $\alpha$, $\beta$ and $\gamma$ are numbers in the range represented by $0.4 \leq x \leq 0.6$, $0.4 \leq y \leq 0.55$, $1.5 \leq \alpha \leq 1.7$, $0.45 \leq \beta \leq 0.5$ and $0 \leq \gamma \leq 3.8$ in which the mean particle size of a powder is no more than 0.09 micrometers.

2. The complex perovskite compound according to claim 1 wherein it is represented by the general formula:

$Pb_{1-x}Sr_x(Zr_{1-y}Ti_y)O_3$
+ $Sb_2O_3$ (1.68 weight percent)
+ $MnO_2$ (0.50 weight percent)
+ $PbO$ (3.85 weight percent)

wherein x is a number in the range represented by $0.4 \leq x \leq 0.6$ and y is a number in the range represented by $0.49 \leq y \leq 0.52$.

3. A process for producing a complex perovskite compound which comprises the steps of blending alkoxide compounds of Pb, Sr, Zr, Ti, Mn and Sb metals in their stoichiometric proportions, mixing said metal alkoxide compounds in an organic solvent having a boiling point of at least 100°C to obtain a mixture, adding water to the mixture at a rate of no more than 5 milliliters per minute based on the organic solvent having dissolved said metal alkoxide compounds to deposit a hydrolyzate, and firing said hydrolyzate.

4. The process according to claim 3 wherein the metal alkoxide compounds are selected from the group consisting of
$Pb(O\text{-}i\text{-}C_3H_7)_2$, $Sr(O\text{-}i\text{-}C_3H_7)_2$, $Zr(O\text{-}i\text{-}C_3H_7)_4$, $Ti(O\text{-}i\text{-}C_3H_7)_4$, $Mn(O\text{-}i\text{-}C_3H_7)_2$, $Sb(O\text{-}i\text{-}C_3H_7)_3$, $Ti(O\text{-}i\text{-}C_4H_9)_4$, $Zr(O\text{-}i\text{-}C_4H_9)_4$, $Ti(OCH_3)_4$, $Zr(OCH_3)_4$, $Sr(OCH_3)_2$ and $Sb(OCH_3)_3$.

5. The process according to claim 3 wherein the solvent is selected from the group consisting of xylene, toluene, pentanol, isobutyl alcohol, nitrobenzene and mixtures thereof.

6. The process according to claim 3 wherein water in an amount of from 10 to 20 times an amount necessary for hydrolysis is added in the hydrolysis step.

7. The process according to claim 3 wherein the hydrolysis is carried out at a temperature of from 90° to 100°C under reflux of said solvent with stirring.

8. The process according to claim 3 wherein a firing procedure comprises calcining at a temperature of from 580° to 650°C and subsequent firing at a temperature of from 850° to 1,000°C.

European Patent Office

EUROPEAN SEARCH REPORT

Application Number

EP    91 71 0019

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| E | WORLD PATENTS INDEX LATEST Derwent Publications Ltd., London, GB; AN 91-250089 & JP-A-3 164 432 (FUJI ELECTROCHEM.) 16 July 1991 * abstract * | 1,3,4,6 | C04B35/49 C01G25/00 H01L41/18 H01B3/12 |
| A |  | 2,5,7,8 | |
| A | DE-A-2 359 818 (TDK ELECTRONICS CO.) * claims; examples 4.1--4.9; table 4 * | 1,2 | |
| A | JOURNAL OF MATERIALS SCIENCE LETTERS. vol. 7, no. 8, August 1988, LONDON GB pages 867 - 869; T.OGIHARA ET AL.: 'PREPARATION OF MONODISPERSED LEAD ZIRCONATE-TITANATE FINE PARTICLES' * page 867, right column, line 1, paragraph 1 - line 11, paragraph 2 * * page 869, left column, line 3, paragraph 2 - line 4, paragraph 2; figure 4; table 1 * | 1,3,4,6 | |
| A | WORLD PATENTS INDEX LATEST Derwent Publications Ltd., London, GB; AN 88-039560 & JP-A-62 298 192 (HITACHI METAL KK) 25 December 1987 | 1-2 | TECHNICAL FIELDS SEARCHED (Int. Cl.5) C04B C01G H01L H01B H01G |
| A | CHEMICAL ABSTRACTS, vol. 93, no. 10, 1980, Columbus, Ohio, US; abstract no. 105584S, TU,LI LONG: 'PIEZOELECTRIC CERAMIC TRANSFORMER' * abstract * | 1-2 | |
| A | US-A-4 565 642 (S.JYOMURA ET AL.) | | |
| A | US-A-3 923 675 (K.S.MAZDIYASNI) | | |
| A | US-A-3 963 630 (M.YONEZAWA ET AL.) | | |

The present search report has been drawn up for all claims

| Place of search | Date of completion of the search | Examiner |
|---|---|---|
| THE HAGUE | 09 JANUARY 1992 | HARBRON J.L. |

EPO FORM 1503 03.82 (P0401)